# EUROPEAN PATENT APPLICATION

(11) **EP 4 394 247 A1**
(43) Date of publication of application: **03.07.2024**
(21) Application number: 23866632.5
(22) Date of filing: 23.02.2023
(51) Int. Cl.: F21V 23/00, H01L 33/00, H01L 33/62, H01L 25/075, H01L 33/48, H01L 33/58

(54) **SMALL LIGHT-EMITTING DIODE (LED) MODULE AND PREPARATION METHOD THEREFOR**

(30) Priority: 26.10.2022 CN 202211320242
(71) Applicant: Sunto Microelectronics (Suzhou) Co., Ltd, Suzhou, Jiangsu 215000 (CN)
(72) Inventor: Yuan, Yuan, Jiangsu 215000 (CN)
(74) Representative: Cabinet Didier Martin
(86) International application number: PCT/CN2023/077772
(87) International publication number: WO 2024/087427

(57) **Abstract**

Provided are a mini light-emitting diode (LED) module and a preparation method for the mini LED module. The mini LED module includes an insulating substrate, a first group of LED chips, a second group of LED chips and a stroboscopic adjustment structure. The insulating substrate includes a first surface and a second surface disposed opposite to the first surface. The first group of LED chips are fixed on the first surface. The second group of LED chips are fixed on the second surface. The stroboscopic adjustment structure is arranged inside the insulating substrate. A first conductive hole and a second conductive hole are provided in the insulating substrate, the stroboscopic adjustment structure is connected to the first group of LED chips through the first conductive hole, and/or the stroboscopic adjustment structure is connected to the second group of LED chips through the second conductive hole.

## Description

The present application claims priority to Chinese Patent Application No. 202211320242.X filed with the China National Intellectual Property Administration (CNIPA) on Oct. 26, 2022, the contents of which is incorporated herein by reference in its entirety.

### TECHNICAL FIELD

The present application relates to the field of lighting packaging technology, such as a mini light emitting diode (LED) module and a preparation method for a mini LED module.

### BACKGROUND

A driver circuit of a light-emitting diode (LED) module includes a rectifier bridge composed of diodes and an output capacitor connected between an output terminal of the rectifier bridge and the ground, where the capacitor is generally an electrolytic capacitor.

The rectifier bridge converts alternating current (AC) electric power (220 Volts/50 Hertz) into direct current (DC) power to supply the LED module, however the DC power supplied to the LED module includes an alternating component of about 100 Hertz, resulting in the stroboscopic effect when the LED module emits light.

For small-sized LED modules, the volume of the electrolytic capacitor is too large to satisfy the packaging miniaturization requirements of mini LED modules.

### SUMMARY

The present application provides a mini light emitting diode (LED) module and a preparation method for a mini LED module, so that the packaging miniaturization requirements of the mini LED module can be satisfied while the stroboscopic phenomenon is eliminated.

According to an aspect of the present application, a mini LED module is provided. The mini LED module includes an insulating substrate, a first group of LED chips, a second group of LED chips and a stroboscopic adjustment structure. The insulating substrate includes a first surface and a second surface disposed opposite to the first surface. The first group of LED chips are fixed on the first surface. The second group of LED chips are fixed on the second surface. The stroboscopic adjustment structure is arranged inside the insulating substrate. A first conductive hole and a second conductive hole are provided in the insulating substrate, the stroboscopic adjustment structure is connected to the first group of LED chips through the first conductive hole, and/or the stroboscopic adjustment structure is connected to the second group of LED chips through the second conductive hole.

According to another aspect of the present application, a preparation method for a mini LED module is provided. The method includes steps described below.

An insulating substrate is prepared, where a stroboscopic adjustment structure is disposed inside the insulating substrate, a first conductive hole and a second conductive hole are provided in the insulating substrate, and the insulating substrate includes a first surface and a second surface disposed opposite to the first surface; a first group of LED chips are formed on the first surface; a second group of LED chips are formed on the second surface; and the stroboscopic adjustment structure is connected to the first group of LED chips through the first conductive hole, and/or the stroboscopic adjustment structure is connected to the second group of LED chips through the second conductive hole.

### BRIEF DESCRIPTION OF DRAWINGS

To illustrate technical solutions in embodiments of the present application, the drawings used in description of the embodiments are described hereinafter. The drawings described hereinafter illustrate part of embodiments of the present application, and those of ordinary skill in the art may obtain other drawings based on the drawings described hereinafter on the premise that no creative work is done.
FIG. 1 is a schematic structural diagram of a mini LED module according to an embodiment of the present application;
FIG. 2 is a schematic top view of a first surface side of a mini LED module according to an embodiment of the present application;
FIG. 3 is a schematic top view of a second surface side of a mini LED module according to an embodiment of the present application;
FIG. 4 is a schematic equivalent circuit diagram of a mini LED module according to an embodiment of the present application;
FIG. 5 is a schematic top view of a first surface side of another mini LED module according to an embodiment of the present application;
FIG. 6 is a schematic structural diagram where capacitors are arranged inside an insulating substrate according to an embodiment of the present application;
FIG. 7 is another schematic structural diagram where capacitors are arranged inside an insulating substrate according to an embodiment of the present application;
FIG. 8 is a schematic flowchart of a preparation method for a mini LED module according to an embodiment of the present application; and
FIG. 9 is a schematic structural diagram corresponding to a respective step(s) of a preparation method for a mini LED module according to an embodiment of the present application; and
FIG. 10 is a schematic structural diagram corresponding to a respective step(s) of a preparation method for a mini LED module according to an embodiment of the present application.

### Reference list

- 001: Insulating substrate
- 002: First group of LED chips
- 003: Second group of LED chips
- 101: First surface
- 102: Second surface
- 004: First driver chip
- 005: Second driver chip
- 006: First wiring layer
- 007: First pad
- 008: Second wiring layer
- 009: Second pad
- 1a: Rectifier bridge
- 1c: LED module
- 101A: First region
- 101B: Second region
- 101C: Third region
- 101D: Fourth region
- T: Insulating sub-substrate
- C: Capacitor
- C1: First electrode-plate
- C2: Second electrode-plate
- C11: First sub-electrode-plate
- C21: Second sub-electrode-plate
- C12: Third sub-electrode-plate
- C22: Fourth sub-electrode-plate
- 10: Stroboscopic adjustment structure
- 20: First conductive hole
- 21: First positive conductive hole
- 22: First negative conductive hole
- 30: Second conductive hole
- 31: Second positive conductive hole
- 32: Second negative conductive hole

### DETAILED DESCRIPTION

Technical solutions in embodiments of the present application are described clearly and completely in conjunction with drawings in the embodiments of the present application from which the technical solutions of the present application are better understood by those skilled in the art. Apparently, the embodiments described below are part, not all, of embodiments of the present application. Based on the embodiments of the present application, all other embodiments obtained by those of ordinary skill in the art without creative work are within the scope of the present application.

It is to be noted that the terms "first", "second" and the like in the description, claims and drawings of the present application are used to distinguish between similar objects and are not necessarily used to describe a particular order or sequence. It is to be understood that data used in this manner is interchangeable in appropriate cases so that the embodiments of the present application described herein can also be implemented in an order not illustrated or described herein. In addition, terms "comprising", "including" and any other variation thereof are intended to encompass a non-exclusive inclusion. For example, a process, method, system, product or device that includes a series of steps or units not only includes the expressly listed steps or units, but may also include other steps or units that are not expressly listed or are inherent to such a process, method, product or device.

To eliminate the stroboscopic phenomenon and satisfy the packaging miniaturization requirements of mini LED modules, an embodiment of the present application provides technical solutions described below.

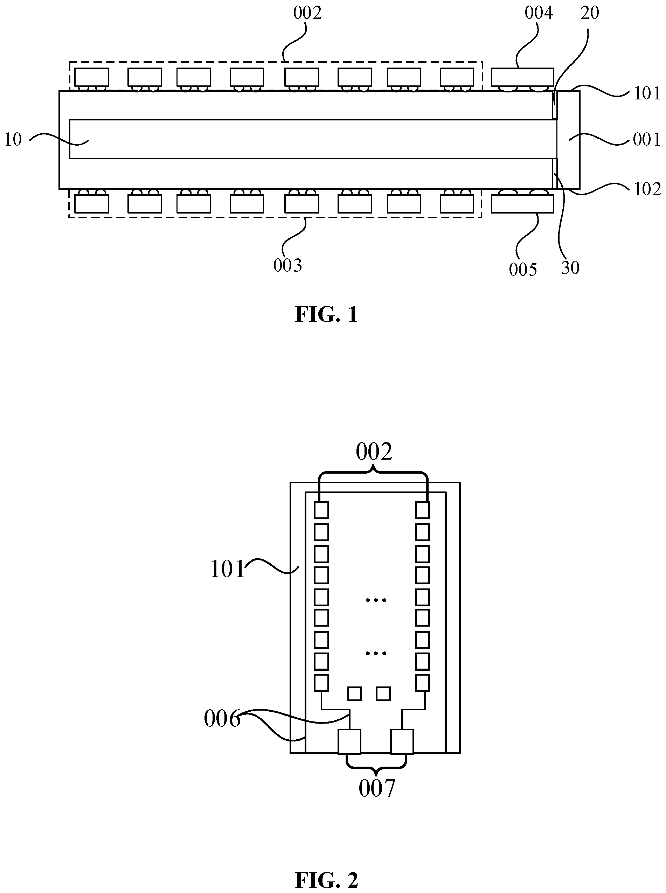

Referring to FIG. 1, FIG. 1 is a structural diagram of a mini LED module according to an embodiment of the present application. The mini LED module includes an insulating substrate 001, a first group of LED chips 002, a second group of LED chips 003 and a stroboscopic adjustment structure 10. The insulating substrate 001 includes a first surface 101 and a second surface 102 disposed opposite to the first surface 101. The first group of LED chips 002 are fixed on the first surface 101. The second group of LED chips 003 are fixed on the second surface 102. The stroboscopic adjustment structure 10 is arranged inside the insulating substrate 001. A first conductive hole 20 and a second conductive hole 30 are provided in the insulating substrate 001, the stroboscopic adjustment structure 10 is connected to the first group of LED chips 002 through the first conductive hole 20, and/or the stroboscopic adjustment structure 10 is connected to the second group of LED chips 003 through the second conductive hole 30.

Optionally, referring to FIG. 1, a first driver chip 004 is further disposed on the first surface 101, and a second driver chip 005 is further disposed on the second surface 102. The first driver chip 004 provides a driver circuit for the first group of LED chips 002 in addition to the stroboscopic adjustment structure 10. For example, the first driver chip 004 is a chip with rectification function. The second driver chip 005 provides a driver circuit for the second group of LED chips 003 in addition to the stroboscopic adjustment structure 10. For example, the second driver chip 005 is a chip with rectification function.

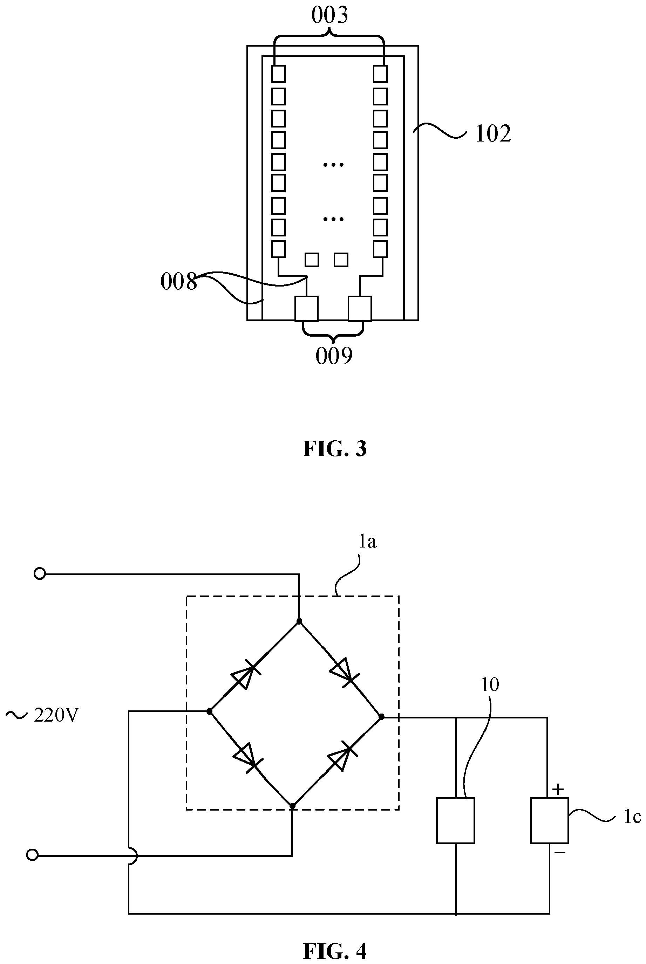

Optionally, referring to FIG. 2, FIG. 2 is a top view of a first surface side of a mini LED module according to an embodiment of the present application. A first wiring layer 006 and first pads 007 are disposed on the first surface 101, and the stroboscopic adjustment structure 10 is connected to the first group of LED chips 002 through the first conductive hole 20, the first pads 007 and the first wiring layer 006. Optionally, referring to FIG. 3, FIG. 3 is a top view of a second surface side of a mini LED module according to an embodiment of the present application. A second wiring layer 008 and second pads 009 are disposed on the second surface 102, and the stroboscopic adjustment structure 10 is connected to the second group of LED chips 003 through the second conductive hole 30, the second pads 009 and the second wiring layer 008.

On the first surface 101, the first wiring layer 006 achieves the connection of the first driver chip 004, the first group of LED chips 002 and the stroboscopic adjustment structure 10. On the second surface 102, the second wiring layer 008 achieves the connection of the second driver chip 005, the second group of LED chips 003 and the stroboscopic adjustment structure 10.

Optionally, referring to FIG. 4, FIG. 4 is an equivalent circuit diagram of a mini LED module according to an embodiment of the present application. The driver circuit of the equivalent circuit of the mini LED module includes a rectifier bridge 1a, the stroboscopic adjustment structure 10 and a mini LED module 1c. The mini LED module 1c includes the first group of LED chips 002 and the second group of LED chips 003.

According to the technical solutions provided in the embodiment, the stroboscopic adjustment structure 10 is used for solving the stroboscopic problem of the mini LED module. As the stroboscopic adjustment structure 10 is arranged inside the insulating substrate 001 and the stroboscopic adjustment structure 10 is connected to the first group of LED chips 002 through the first conductive hole 20 inside the insulating substrate 001 and/or the stroboscopic adjustment structure 10 is connected to the second group of LED chips 003 through the second conductive hole 30 inside the insulating substrate 001, the stroboscopic adjustment structure 10 does not occupy the surface area of the insulating substrate 001 of the mini LED module, and thereby not increasing the volume of the insulating substrate 001. Therefore, the packaging miniaturization requirements of the mini LED module can be satisfied.

Optionally, on the basis of the preceding technical solutions, a size of a plane of the mini LED module in a first direction is less than or equal to 80 millimeters, and a size of the plane of the mini LED module in a second direction is less than or equal to 20 millimeters, where the first direction of the plane and the second direction of the plane are perpendicular to each other.

That is, the dimension of the plane of the mini LED module is within 80mm×20mm. When an electrolytic capacitor in the related art is used in such a small LED module as the stroboscopic adjustment structure 10, it is impossible to limit the dimension of the plane of the LED module to 80mm×20mm. According to the technical solutions of the embodiment of the present application, the stroboscopic adjustment structure 10 is arranged inside the insulating substrate 001, not occupying the surface area of the insulating substrate 001 of the mini LED module, and thereby not increasing the volume of the insulating substrate 001. Therefore, the packaging miniaturization requirements of the mini LED module can be satisfied.

Optionally, on the basis of the preceding technical solutions, referring to FIG. 1, the stroboscopic adjustment structure 10 includes at least one capacitor C. Each capacitor C includes two electrode-plates which are insulated, and the two electrode-plates are spaced by the insulating substrate 001.

Two electrodes plates which are insulated form a capacitor C, and the stroboscopic adjustment structure 10 includes at least one capacitor C to replace the electrolytic capacitor in the related art. In this manner, for a small-sized LED module, the volume of the electrolytic capacitor is avoided being too large to satisfy the packaging miniaturization requirements of the mini LED module. Therefore, the packaging miniaturization requirements of the mini LED module can be satisfied while the stroboscopic phenomenon is eliminated. The number of the capacitors C and the series relationship or the parallel relationship of the capacitors C may be set according to actual requirements.

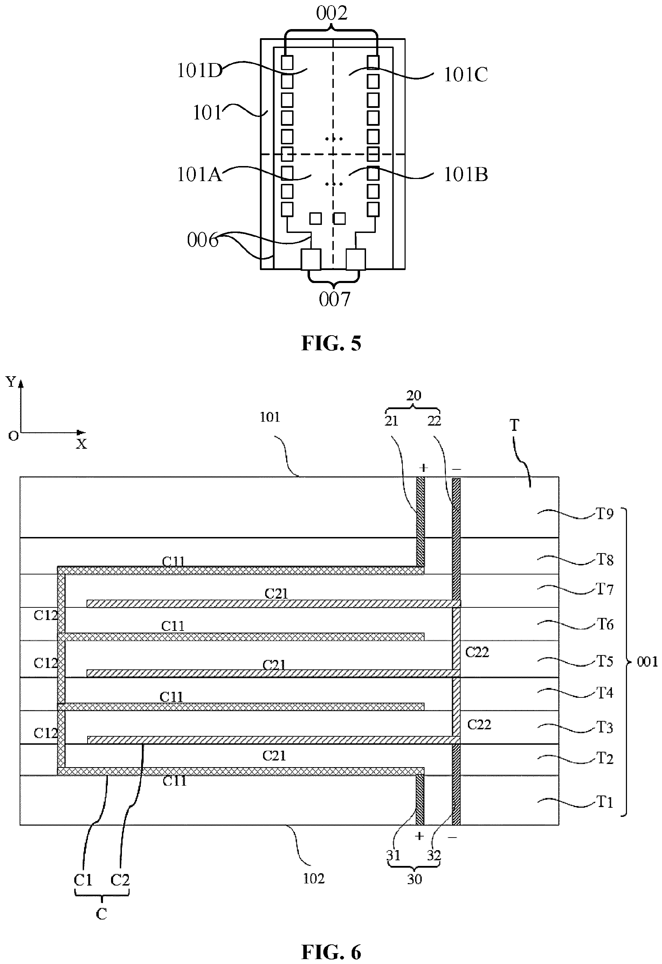

Optionally, referring to FIG. 5, FIG. 5 is a top view of a first surface side of another mini LED module according to an embodiment of the present application. In an example, when the stroboscopic adjustment structure 10 includes four capacitors C, a first capacitor C is arranged inside the insulating substrate 001 in a first region 101A, a second capacitor C is arranged inside the insulating substrate 001 in a second region 101B, a third capacitor C is arranged inside the insulating substrate 001 in a third region 101C, and a fourth capacitor C is arranged inside the insulating substrate 001 in a fourth region 101D. The number of capacitors included in the stroboscopic adjustment structure 10 in the embodiment of the present application may be set according to actual requirements.

It is to be noted that the region for the layout of capacitors C in the insulating substrate 001 may be determined according to requirements.

Optionally, the stroboscopic adjustment structure 10 includes at least two capacitors C, and any two capacitors C are connected in parallel or in series so that the desired dielectric withstand voltage value of the stroboscopic adjustment structure 10 can be achieved.

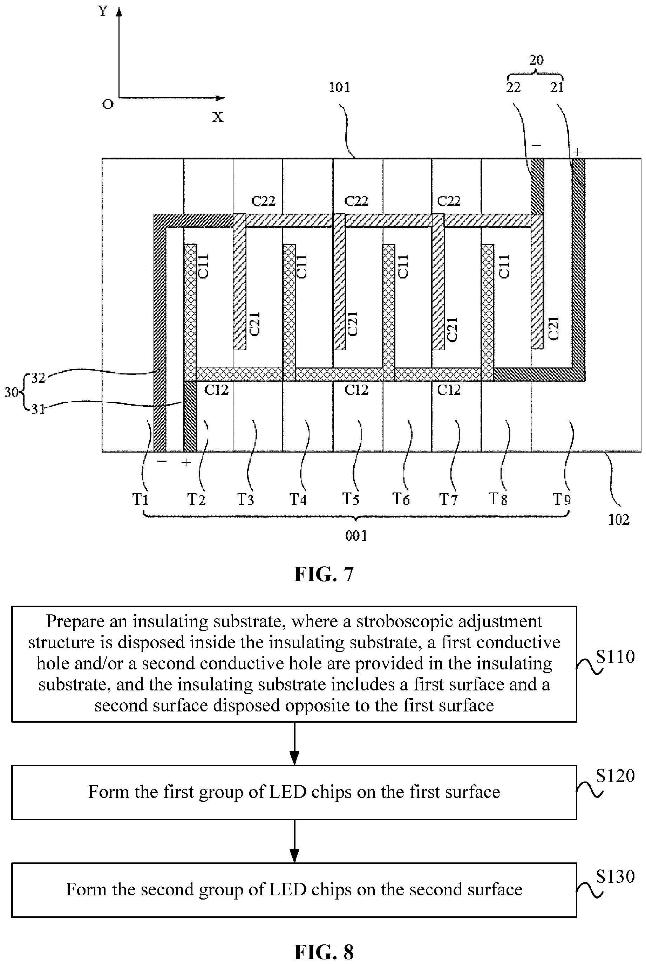

Optionally, on the basis of the preceding technical solutions, referring to FIG. 6 and FIG. 7, FIG. 6 is a structural diagram where capacitors are arranged inside an insulating substrate according to an embodiment of the present application, and FIG. 7 is another structural diagram where capacitors are arranged inside an insulating substrate according to an embodiment of the present application. The insulating substrate 001 includes at least three insulating sub-substrates T, and the at least three insulating sub-substrates T are parallel in the first direction (in FIG. 6, the first direction is direction Y, the first direction is a perpendicular direction from the first surface 101 to the second surface 102, and the second direction is direction X, and the second direction is perpendicular to the first direction; in FIG. 7, the second direction is direction Y, the second direction is a perpendicular direction from the first surface 101 to the second surface 102, and the second direction is X, and the second direction is perpendicular to the first direction ).

In an example, in FIG. 6 and FIG. 7, the insulating substrate 001 includes insulating sub-substrate T1, insulating sub-substrate T2 and insulating sub-substrate T3. In addition, the insulating substrate 001 further includes insulating sub-substrate T4, insulating sub-substrate T5, insulating sub-substrate T6, insulating sub-substrate T7, insulating sub-substrate T8 and insulating sub-substrate T9. That is, the insulating substrate 001 includes nine insulating substrates T.

Each capacitor C includes a first electrode-plate C1 and a second electrode-plate C2 which are insulated. The first electrode-plate C1 includes at least one first sub-electrode-plate C11, the second electrode-plate C2 includes at least one second sub-electrode-plate C21, and the first sub-electrode-plate C11 and the second sub-electrode-plate C21 are parallel in the first direction.

In an example, referring to FIG. 6, the first electrode-plate C1 includes four first sub-electrode-plates C11, and the second electrode-plate C2 includes three second sub-electrode-plates C21. Referring to FIG. 7, the first electrode-plate C1 includes four first sub-electrode-plates C11, and the second electrode-plate C2 includes four second sub-electrode-plates C21.

A first sub-electrode-plate C11 and a second sub-electrode-plate C21 are insulated by an insulating substrate T. An insulating sub-substrate T is disposed on a surface of the first sub-electrode-plate C11 facing away from the second sub-electrode-plate C2, and an insulating substrate T is disposed on a surface of the second sub-electrode-plate C21 facing away from the first sub-electrode-plate C11.

Optionally, referring to FIG. 6 and FIG. 7, the first electrode-plate C1 includes at least two first sub-electrode-plates C11 which are parallel in the first direction, and the second electrode-plate C2 includes at least two second sub-electrode-plates C21 which are parallel in the first direction. A second sub-electrode-plate C21 is disposed between two adjacent first sub-electrode-plates C11, or a first sub-electrode-plate C11 is disposed between two adjacent second sub-electrode-plates C21. The first electrode-plate C1 further includes a third sub-electrode-plate C12, where the third sub-electrode-plate C12 is used for connecting two adjacent first sub-electrode-plates C11 in a connecting hole provided in the insulating substrate 001 in the second direction. The second electrode-plate C2 further includes a fourth sub-electrode-plate C22, where the fourth sub-electrode-plate C22 is used for connecting two adjacent second sub-electrode-plates C21 in a connecting hole provided in the insulating substrate 001 in the second direction.

In an example, first sub-electrode-plates C11 and second sub-electrode-plates C21 are disposed in parallel in the first direction. Two adjacent first sub-electrode-plates C11 are electrically connected through the third sub-electrode-plate C12 disposed in the second direction, two adjacent second sub-electrode-plates C21 are electrically connected through the fourth sub-electrode-plate C22 disposed in the second direction, and the insulation between two adjacent sub-electrode-plates is achieved through the insulating substrate 001. The dielectric withstand voltage value of the capacitor C may be adjusted by the adjustment on the number and area of first sub-electrode-plates C11, the number and area of second sub-electrode-plates C21 and the permittivity of the insulating substrate 001.

It is to be noted that the first conductive hole 20 includes a first positive conductive hole 21 and a first negative conductive hole 22, and the second conductive hole 30 includes a second positive conductive hole 31 and a second negative conductive hole 32. Referring to FIG. 6 and FIG. 7, in an example, capacitors inside the insulating substrate 001 are connected to the first group of LED chips 002 through the first conductive hole 20, and capacitors inside the insulating substrate 001 are connected to the second group of LED chips 003 through the second conductive hole 30. Moreover, capacitors inside the insulating substrate 001 may be connected to the first group of LED chips 002 through the first conductive hole 20 or to the second group of LED chips 003 through the second conductive hole 30 according to actual requirements.

An embodiment of the present application further provides a preparation method for a mini LED module. Referring to FIG. 8, FIG. 8 is a flowchart of a preparation method for a mini LED module according to an embodiment of the present application. The preparation method for a mini LED module includes steps described below.

In S110, an insulating substrate is prepared, where a stroboscopic adjustment structure is disposed inside the insulating substrate, a first conductive hole and a second conductive hole are provided in the insulating substrate, and the insulating substrate includes a first surface and a second surface disposed opposite to the first surface.

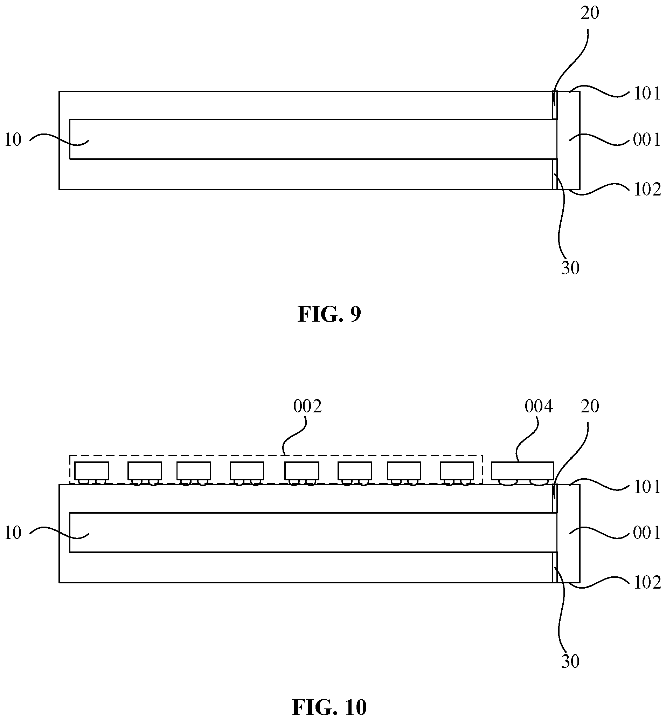

Referring to FIG. 9, the insulating substrate 001 is prepared. The insulating substrate 001 includes the first surface 101 and the second surface 102 disposed opposite to the first surface 101. The first conductive hole 20 and the second conductive hole 30 are provided in the insulating substrate 001, and the stroboscopic adjustment structure 10 is disposed inside the insulating substrate 001. The stroboscopic adjustment structure 10 is connected to a first group of LED chips 002 through the first conductive hole 20, and/or the stroboscopic adjustment structure 10 is connected to a second group of LED chips 003 through the second conductive hole 30. In an example, the insulating substrate 001 may be composed of multiple insulating sub-substrates T. The stroboscopic adjustment structure 10 is formed on a surface of an insulting sub-substrate T, and another insulating subs-substrate T is formed on a surface of the stroboscopic adjustment structure 10. The first conductive hole 20 and the second conductive hole 30 may be formed inside the insulating substrate 001 through the patterning process and the electroplating process.

In S120, the first group of LED chips are formed on the first surface.

Referring to FIG. 10, the first group of LED chips 002 may be formed on the first surface 101 in the manner of flip chip or wire bonding.

In S130, the second group of LED chips are formed on the second surface.

Referring to FIG. 1, the second group of LED chips 003 may be formed on the second surface 102 in the manner of flip chip or wire bonding.

Optionally, referring to FIG. 2, a first wiring layer 006 and first pads 007 may further be formed on the first surface 101 while the first group of LED chips 002 are formed on the first surface 101. The stroboscopic adjustment structure 10 is connected to the first group of LED chips 002 through the first conductive hole 20, the first pads 007 and the first wiring layer 006.

Optionally, referring to FIG. 3, a second wiring layer 008 and second pads 009 may further be formed on the second surface 102 while the second group of LED chips 003 are formed on the second surface 102. The stroboscopic adjustment structure 10 is connected to the second group of LED chips 003 through the second conductive hole 30, the second pads 009 and the second wiring layer 008.

According to the mini LED module formed in the embodiment, the stroboscopic adjustment structure 10 is used for solving the stroboscopic problem of the mini LED module. As the stroboscopic adjustment structure 10 is arranged inside the insulating substrate 001, and the stroboscopic adjustment structure 10 is connected to the first group of LED chips 002 through the first conductive hole 20 inside the insulating substrate 001, and/or the stroboscopic adjustment structure 10 is connected to the second group of LED chips 003 through the second conductive hole 30 inside the insulating substrate 001, the stroboscopic adjustment structure 10 does not occupy the surface area of the insulating substrate 001 of the mini LED module, and thereby not increasing the volume of the insulating substrate 001. Therefore, the packaging miniaturization requirements of the mini LED module can be satisfied.

Optionally, on the basis of the preceding technical solutions, S110 in which the insulating substrate is prepared includes the step described below.

At least one capacitor is formed inside the insulating substrate 001, where each capacitor includes two electrode-plates which are insulated, and the two electrode-plates are spaced by the insulating substrate 001.

In an example, two electrodes plates which are insulated form a capacitor C, and the stroboscopic adjustment structure 10 includes at least one capacitor C which is used for replacing the electrolytic capacitor in the related art. In this manner, for a small-sized LED module, the volume of the electrolytic capacitor is avoided being too large to satisfy the packaging miniaturization requirements of the mini LED module. Therefore, the packaging miniaturization requirements of the mini LED module can be satisfied while the stroboscopic phenomenon is eliminated. The number of the capacitors C and the series relationship or the parallel relationship of the capacitors C may be set according to actual requirements.

Optionally, on the basis of the preceding technical solutions, the insulating substrate 001 includes at least three insulating sub-substrates T, and the at least three insulating sub-substrates T are parallel in a first direction. Each capacitor C includes a first electrode-plate C1 and a second electrode-plate C2 which are insulated. The first electrode-plate C1 includes at least one first sub-electrode-plate C11, the second electrode-plate C2 includes at least one second sub-electrode-plate C21, and the at least one first sub-electrode-plate C11 and the at least one second sub-electrode-plate C21 are parallel in the first direction. The structural diagrams shown in FIG. 6 and FIG. 7 are taken as examples for illustration, and forming the first electrode C 1 and the second electrode C2 which are insulated inside the insulating substrate 001 includes the step described below.

The at least three insulating sub-substrates T, the at least one first sub-electrode-plate and the at least one second sub-electrode-plate are formed, where the first sub-electrode-plate and the second sub-electrode-plate are insulated by an insulating substrate T, an insulating sub-substrate T is disposed on a surface of the first sub-electrode-plate facing away from the second sub-electrode-plate, and an insulating substrate T is disposed on a surface of the second sub-electrode-plate facing away from the first sub-electrode-plate.

Referring to FIG. 6 and FIG. 7, the at least three insulating sub-substrates T, the at least one first sub-electrode-plate C11 and the at least one second sub-electrode-plate C21 are formed, where a first sub-electrode-plate C11 and a second sub-electrode-plate C21 are insulated by an insulating substrate T, an insulating sub-substrate T is disposed on a surface of the first sub-electrode-plate C11 facing away from the second sub-electrode-plate C2, and an insulating substrate T is disposed on a surface of the second sub-electrode-plate C21 facing away from the first sub-electrode-plate C11.

Optionally, to achieve the electrical connection of first sub-electrode-plates C11 disposed in parallel in the first direction, second sub-electrode-plates C21 disposed in parallel in the first direction are required. To achieve the electrical connection of second sub-electrode-plates C21 disposed in parallel in the first direction, fourth sub-electrode-plates C22 disposed in parallel in the first direction are required. A second sub-electrode-plate C21 is disposed between two adjacent first sub-electrode-plates C11, or a first sub-electrode-plate C11 is disposed between two adjacent second sub-electrode-plates C21. The first electrode-plate C1 further includes the third sub-electrode-plate C12, where the third sub-electrode-plate C12 is used for connecting two adjacent first sub-electrode-plates C11 in a connecting hole provided in the insulating substrate 001 in a second direction. The second electrode-plate C2 further includes the fourth sub-electrode-plate C22, where the fourth sub-electrode-plate C22 is used for connecting two adjacent second sub-electrode-plates C21 in a connecting hole provided in the insulating substrate 001 in the second direction.

In an example, first sub-electrode-plates C11 and second sub-electrode-plates C21 are disposed in parallel in the first direction. Two adjacent first sub-electrode-plates C11 are electrically connected through the third sub-electrode-plate C12 disposed in the second direction, two adjacent second sub-electrode-plates C21 are electrically connected through the fourth sub-electrode-plate C22 disposed in the second direction, and the insulation between two adjacent sub-electrode-plates is achieved through the insulating substrate 001. The dielectric withstand voltage value of the capacitor C may be adjusted by the adjustment of the number and area of first sub-electrode-plates C11, the number and area of second sub-electrode-plates C21 and the permittivity of the insulating substrate 001.

In an example, in FIG. 6, the first direction is direction Y, the first direction is a perpendicular direction from the first surface 101 to the second surface 102, and the second direction is direction X, and the second direction is perpendicular to first direction; in FIG. 7, the second direction is direction Y, the second direction is a perpendicular direction from the first surface 101 to the second surface 102 , and the second direction is direction X, and the second direction is perpendicular to the first direction.

## Claims

1. A mini light-emitting diode, LED, module, comprising:
an insulating substrate (001), wherein the insulating substrate (001) comprises a first surface (101) and a second surface (102) disposed opposite to the first surface (101);
a first group of LED chips (002), wherein the first group of LED chips (002) are fixed on the first surface (101);
a second group of LED chips (003), wherein the second group of LED chips (003) are fixed on the second surface (102); and
a stroboscopic adjustment structure (10), wherein the stroboscopic adjustment structure (10) is arranged inside the insulating substrate (001);
wherein a first conductive hole (20) and a second conductive hole (30) are provided in the insulating substrate (001), the stroboscopic adjustment structure (10) is connected to the first group of LED chips (002) through the first conductive hole (20), and/or the stroboscopic adjustment structure (10) is connected to the second group of LED chips (003) through the second conductive hole (30).

2. The mini LED module according to claim 1, wherein a size of a plane of the mini LED module in a first direction is less than or equal to 80 millimeters, a size of the plane of the mini LED module in a second direction is less than or equal to 20 millimeters, and the first direction of the plane and the second direction of the plane are perpendicular to each other.

3. The mini LED module according to claim 1, wherein the stroboscopic adjustment structure (10) comprises at least one capacitor (C), each capacitor (C) of the at least one capacitor (C) comprises two electrode-plates which are insulated, and the two electrode-plates are spaced by the insulating substrate (001).

4. The mini LED module according to claim 3, wherein the stroboscopic adjustment structure (10) comprises at least two capacitors (C), and any two capacitors (C) of the at least two capacitors (C) are connected in parallel or in series.

5. The mini LED module according to claim 3, wherein the insulating substrate (001) comprises at least three insulating sub-substrates (T), and the at least three insulating sub-substrates (T) are parallel in the first direction;
each of the at least one capacitor (C) comprises a first electrode-plate (C1) and a second electrode-plate (C2) which are insulated, the first electrode-plate (C1) comprises at least one first sub-electrode-plate (C11), the second electrode-plate (C2) comprises at least one second sub-electrode-plate (C21), and the at least one first sub-electrode-plate (C11) and the at least one second sub-electrode-plate (C21) are parallel in the first direction; and
a first sub-electrode-plate (C11) of the at least one first sub-electrode-plate (C11) and a second sub-electrode-plate (C21) of the at least one second sub-electrode-plate (C21) are insulated through an insulating sub-substrate (T) of the at least three insulating sub-substrates (T), an insulating sub-substrate (T) of the at least three insulating sub-substrates (T) is disposed on a surface of the first sub-electrode-plate (C11) facing away from the second sub-electrode-plate (C21), and an insulating sub-substrate (T) of the at least three insulating sub-substrates (T) is disposed on a surface of the second sub-electrode-plate (C21) facing away from the first sub-electrode-plate (C11).

6. The mini LED module according to claim 5, wherein the first electrode-plate (C1) comprises at least two first sub-electrode-plates (C11) which are parallel in the first direction, and the second electrode-plate (C2) comprises at least two second sub-electrode-plates (C21) which are parallel in the first direction;
a second sub-electrode-plate (C21) of the at least two second sub-electrode-plates (C21) is disposed between two adjacent first sub-electrode-plates (C11) of the at least two first sub-electrode-plates (C11), or a first sub-electrode-plate (C11) of the at least two first sub-electrode-plates (C11) is disposed between two adjacent second sub-electrode-plates (C21) of the at least two second sub-electrode-plates (C21);
the first electrode-plate (C1) further comprises a third sub-electrode-plate (C12), wherein the third sub-electrode-plate (C12) is used for connecting two adjacent first sub-electrode-plates (C11) of the at least two first sub-electrode-plates (C11) in a connecting hole provided in the insulating substrate (001) in the second direction; and
the second electrode-plate (C2) further comprises a fourth sub-electrode-plate (C22), wherein the fourth sub-electrode-plate (C22) is used for connecting two adjacent second sub-electrode-plates (C21) of the at least two second sub-electrode-plates (C21) in a connecting hole provided in the insulating substrate (001) in the second direction.

7. The mini LED module according to claim 6, wherein the first direction is a perpendicular direction from the first surface (101) to the second surface (102), and the second direction is perpendicular to the first direction; or
the second direction is a perpendicular direction from the first surface (101) to the second surface (102), and the second direction is perpendicular to the first direction.

8. A preparation method for a mini light-emitting diode, LED, module, comprising:
preparing an insulating substrate, wherein a stroboscopic adjustment structure is disposed inside the insulating substrate, a first conductive hole and a second conductive hole are provided in the insulating substrate, and the insulating substrate comprises a first surface and a second surface disposed opposite to the first surface;
forming a first group of LED chips on the first surface; and
forming a second group of LED chips on the second surface;
wherein the stroboscopic adjustment structure is electrically connected to the first group of LED chips through the first conductive hole, and/or the stroboscopic adjustment structure is electrically connected to the second group of LED chips through the second conductive hole.

9. The preparation method for a mini LED module according to claim 8, wherein preparing the insulating substrate comprises:
forming at least one capacitor inside the insulating substrate, wherein each capacitor of the at least one capacitor comprises two electrode-plates which are insulated, and the two electrode-plates are spaced by the insulating substrate.

10. The preparation method for a mini LED module according to claim 9, wherein the insulating substrate comprises at least three insulating sub-substrates, and the at least three insulating sub-substrates are parallel in a first direction;
each of at least one capacitor comprises a first electrode-plate and a second electrode-plate which are insulated, the first electrode-plate comprises at least one first sub-electrode-plate, the second electrode-plate comprises at least one second sub-electrode-plate, and the at least one first sub-electrode-plate and the at least one second sub-electrode-plate are parallel in the first direction; and
forming the first electrode and the second electrode which are insulated inside the insulating substrate comprises:
forming the at least three insulating sub-substrates, the at least one first sub-electrode-plate and the at least one second sub-electrode-plate, wherein a first sub-electrode-plate of the at least one first sub-electrode-plate and a second sub-electrode-plate of the at least one second sub-electrode-plate are insulated through an insulating sub-substrate of the at least three insulating sub-substrates, an insulating sub-substrate of the at least three insulating sub-substrates is disposed on a surface of the first sub-electrode-plate facing away from the second sub-electrode-plate, and an insulating sub-substrate of the at least three insulating sub-substrates is disposed on a surface of the second sub-electrode-plate facing away from the first sub-electrode-plate.
